**Europäisches Patentamt**

(19) **European Patent Office**

**Office européen des brevets**

(11) Numéro de publication: **0 092 474**
**B1**

(12) # FASCICULE DE BREVET EUROPÉEN

(45) Date de publication du fascicule du brevet:
23.07.86

(51) Int. Cl.⁴: **H 04 L 27/14,** H 03 H 9/72

(21) Numéro de dépôt: **83400742.9**

(22) Date de dépôt: **14.04.83**

(54) **Filtre de démodulation de signal modulé binairement en fréquence.**

(30) Priorité: **16.04.82 FR 8206598**

(43) Date de publication de la demande:
**26.10.83 Bulletin 83/43**

(45) Mention de la délivrance du brevet:
**23.07.86 Bulletin 86/30**

(84) Etats contractants désignés:
**DE GB NL**

(56) Documents cité:
**FR-A-1 158 969**
**FR-A-2 167 405**
**US-A-4 315 228**

(73) Titulaire: **L'Etat Français, représenté par le Ministre des P.T.T. (Centre National d'Etudes des Télécommunications), 38- 40 rue du Général Leclerc, F-92131 Issy- Les- Moulineaux (FR)**

(72) Inventeur: **Picquendar, Jean Edgar, 25, rue du Docteur Bourdon, F-78470 Saint Remy Les Chevreuse (FR)**
Inventeur: **Henaff, Jeannine, 3 Ter, Place Marquis, F-92140 Clamart (FR)**
Inventeur: **Feldmann, Michel, 45, rue Saint Lambert, F-75015 Paris (FR)**

(74) Mandataire: **Mongrédien, André, c/o BREVATOME 25, rue de Ponthieu, F-75008 Paris (FR)**

EP 0 092 474 B1

## Description

La présente invention concerne les démodulateurs capables de restituer un code binaire avec lequel on a codé un signal analogique en affectant à ce dernier deux fréquences distinctes $F_a$ et $F_b$ correspondant chacune à un état binaire donné du code. Un tel démodulateur reçoit donc un signal analogique sous forme d'une succession de trains de sinusoïdes dont la fréquence est soit $F_a$ soit $F_b$, et il doit fournir une succession de niveaux logiques correspondant à la succession des fréquences qui lui parviennent.

Il s'agit par conséquent d'un démodulateur de signal modulé en fréquence de façon binaire, ou démodulateur F.S.K., de l'anglais "Frequency Shift Keying" signifiant codage par déplacement de fréquence.

De tels démolulateurs F.S.K. existent notamment en téléphonie pour transmettre un code binaire par deux fréquences (en pratique 1300 Hz et 2100 Hz) dans le spectre audible qui est compatible avec la bande passante des lignes téléphoniques. Ces démodulateurs utilisent des filtres à capacités commutées et des filtres à transfert de charges.

La transposition à des fréquences beaucoup plus élevées n'est pas possible compte tenu des limitations en fréquence de ces sortes de filtres. Or, il est nécessaire de passer à des fréquences de codage $F_a$ et $F_b$ très élevées dans le cas où on veut transmettre un débit d'informations binaires élevées. On conçoit en effet que si les fréquences de codage sont 1300 Hz et 2100 Hz, il faut au minimum une période de signal à 1300 Hz pour reconnaître qu'il s'agit de la fréquence 1300 Hz et non de la fréquence 2100 Hz. Le débit d'informations binaires est donc limité en tout état de cause à un maximum de 1300 bits/seconde.

Pour un grand nombre d'applications telles que les télécommunications par satellite pour la transmission de signal de télévision, de communication téléphoniques multiplexées, de son numérisé, de télétextes etc, on désire accéder à un débit beaucoup plus élevé. Un débit de 2,048 Mégabits/seconde est un débit typiquement souhaité.

On pourrait utiliser des filtres à inductances et capacités, pouvant facilement travailler à des fréquences élevées. Mais, ces filtres sont des filtres récursifs ayant donc une réponse impulsionnelle longue (théoriquement infinie), et on s'aperçoit que si le débit d'informations est élevé à l'entrée, il y a un risque important d'interférences entre deux informations binaires successives traversant les filtres, ceci d'autant plus que les filtres sont plus sélectifs. Comme la sélectivité est rendue nécessaire par la proximité des fréquences $F_a$ et $F_b$ à discriminer, car on souhaite réduire au maximum la largeur de bande de la modulation en fréquence, on est conduit à une impasse si on veut à la fois obtenir un débit d'informations binaires très élevé et une modulation de largeur limitée.

Pour résoudre ces différents problèmes, la présente invention propose un circuit comportant, sur la surface d'un cristal piézoélectrique, deux ensembles de filtrage à ondes acoustiques de surface utilisant des transducteurs à peignes d'électrodes interdigitées déposées sur le cristal.

On connaît déjà des circuits comprenant deux tels ensembles. Le document FR—A—2 167 405 décrit, par exemple, un discriminateur comprenant deux filtres légèrement décalés en fréquence. Chaque filtre possède une réponse spectrale en forme de triangle, le sommet de l'une des réponses correspondant à l'une des bases pour l'autre. Autrement dit, lorsque l'affaiblissement est faible pour l'un des filtres, il est fort pour l'autre. Les deux réponses spectrales se combinent pour donner une réponse en forme de S avec une partie linéaire dans un segment central où s'effectue la discrimination.

Dans l'invention, il ne s'agit plus de convertir un signal modulé en fréquence en signal modulé en amplitude mais de filtrer un même signal dans deux filtres différents avec des contraintes bien particulières qui ont été évoquées plus haut. A cette fin, l'invention propose d'utiliser deux filtres dont les caractéristiques structurelles sont adaptées à ce problème, notamment en ce qui concerne le nombre d'électrodes et la réponse impulsionnelle de chaque filtre.

De façon précise, l'invention a pour objet un circuit constitué, comme indiqué ci-dessus, de deux ensembles de filtrage, ce circuit étant caractérisé en ce que, pour constituer un filtre pour la démodulation d'un signal analogique qui est modulé en fréquence selon un code binaire par commutation de la fréquence du signal entre les deux fréquences $F_a$ et $F_b$ ($F_b$ supérieur à $F_a$), chaque ensemble de filtrage comprend un premier peigne de quelques électrodes et un second peigne ayant un nombre d'électrodes notablement plus grand, sensiblement égal à deux fois

$$(2F_a - F_b)/2(F_b - F_a)$$

pour le premier ensemble et deux fois

$$. (2F_b - F_a)/2(F_b - F_a)$$

pour le deuxième, le pas d des électrodes successives reliées à un même potentiel étant pratiquement égal à $v/(2F_a - F_b)$ pour le premier ensemble et $v/(2F_b - F_a)$ pour le deuxième, où v est la vitesse de propagation des ondes à la surface du cristal piézoélectrique, et en ce que la réponse impulsionnelle de durée Tr est sensiblement égale à $0,5/(F_b - F_a)$.

On entendra par affaiblissement "relatif", dans la suite de la description et dans les revendications, l'affaiblissement par rapport au maximum de la courbe de réponse en fréquence, ce maximum ayant un affaiblissement pris par hypothèse égal à zéro décibel.

Le peigne de réception peut être non modulé (électrodes toutes de même longueur) ou modulé (électrodes de longueurs variables) pour modifier la forme de la courbe de réponse en fréquence.

Le peigne de réception peut, en particulier, être modulé de façon à comporter deux groupes de doigts séparés par un espace vide, la largeur du peigne complet restant sensiblement la même.

Bien entendu, du fait de la réciprocité, il est possible d'échanger les caractéristiques des peignes d'émission et de réception, la réponse impulsionnelle globale, comme la réponse en fréquence globale restant inchangées.

Dans une version particulière de réalisation que l'on détaillera, chaque ensemble de filtrage comporte un peigne d'émission et deux demi-peignes de réception placés en regard du peigne d'émission. Les deux demi-peignes de réception sont identiques mais l'un est reculé par rapport à l'autre, dans le sens perpendiculaire aux électrodes des peignes, d'une distance sensiblement égale à $v/4F_a$ pour le premier ensemble de filtrage et $v/4F_b$ pour le deuxième; en pratique, ces distances pourront être prises approximativement égales à un quart du pas entre deux électrodes consécutives de même potentiel des demi-peignes de réception. On obtient ainsi pour chaque ensemble de filtrage deux demi-filtres fournissant des signaux identiques en quadrature de phase, signaux qui peuvent être élevés au carré (par passage à travers des diodes) et additionnés pour réaliser une détection particulièrement simple et efficace.

Le filtre de démodulation selon l'invention présente l'avantage d'une grande facilité de réalisation, d'une bonne stabilité, et d'une possibilité de démodulation à rythme élevé (faible produit durée de bit par largeur de bande de modulation, compatible avec une bonne probabilité de détection en présence de bruit).

D'autres caractéristiques et avantages de l'invention apparaîtront à la lecture de la description détaillée qui suit et qui est faite en référence aux dessins annexés dans lesquels:

— la figure 1 représente un schéma de principe très simplifié de démodulateur F.S.K.;
— la figure 2 représente un exemple de dispositif à ondes de surface, en vue de dessus;
— la figure 3 représente la courbe de réponse en fréquence du dispositif de la figure 2;
— la figure 4 représente les courbes de réponse juxtaposées de deux dispositifs tels que celui de la figure 2;
— la figure 5a et la figure 5b montrent des courbes expliquant les variations de la probabilité d'erreur de détection;
— la figure 6 et la figure 7 montrent deux variantes de courbes de réponse qu'on peut chercher à obtenir;
— la figure 8 montre un filtre à ondes de surface selon l'invention, à peignes non modulés;
— la figure 9 montre un filtre à ondes de surface selon l'invention, à peignes de réception modulés;
— la figure 10 montre les courbes de réponse qu'on peut obtenir avec un filtre à peignes modulés;
— la figure 11 montre un filtre à deux demi-peignes déphasés, dans chaque voie de filtrage;
— la figure 12 montre un démodulateur à détection simplifiée utilisant le filtre de la figure 11.

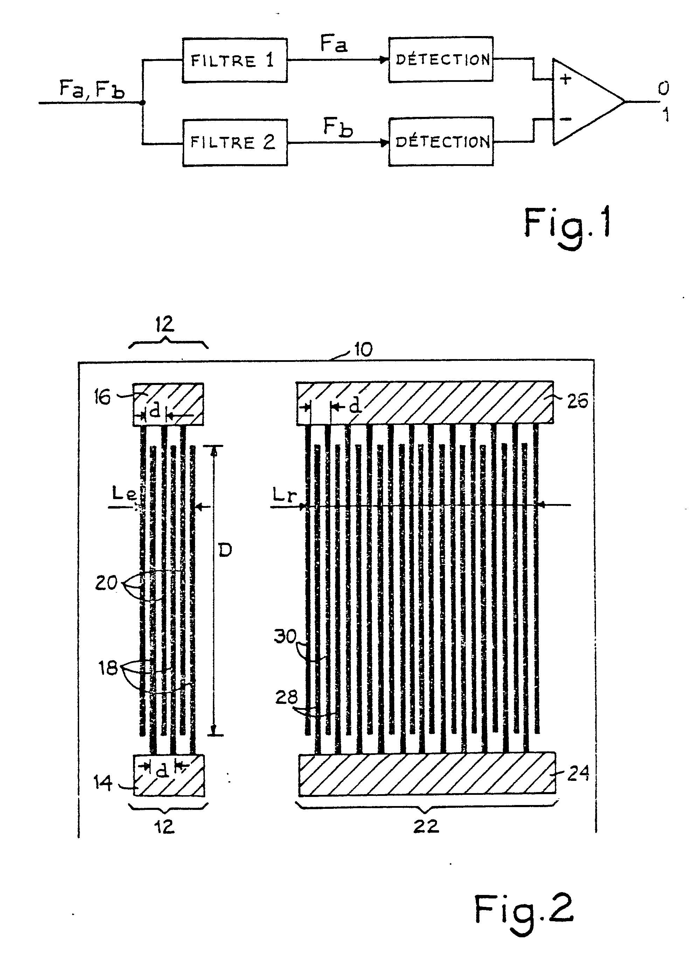

La démodulation F.S.K. nécessite la séparation du signal analogique reçu en deux voies de filtrage, l'une affaiblissant la fréquence $F_b$ plus que la fréquence $F_a$ et l'autre effectuant l'opération inverse. La détection de la présence ou l'absence de signal sur chaque voie et la comparaison des signaux détectés permettent de reconstituer la succession d'informations binaires qui a servi à coder le signal analogique (Figure 1).

Selon l'invention, on réalise sur un même cristal piézoélectrique deux ensembles de filtrage à ondes de surface réalisant des fonctions de transfert en z à réponse impulsionnelle finie, ayant des zéros de transmission assignés à des fréquences convenablement choisies par rapport à $F_a$ et $F_b$, et réalisant l'affaiblissement de chacune des fréquences par rapport à l'autre.

Un exemple de réalisation d'un dispositif à ondes de surface utilisable dans un ensemble de filtrage est représenté en vue très agrandie à la figure 2. Cet ensemble comprend deux transducteurs réalisés sous forme de peignes d'électrodes interdigitées déposées sur la surface polie d'un cristal piézoélectrique 10.

Un peigne d'émission 12 comporte deux plots métalliques 14 et 16 entre lesquels est appliquée la tension analogique à filtrer. Au plot 14 sont reliées plusieurs électrodes ou dents sous forme de rubans rectilignes parallèles allongés 18, espacés d'un pas constant d. Au plot 16 sont reliées autant d'électrodes sous forme de rubans rectilignes parallèles 20, espacés du même pas constant d et placés rigoureusement à équidistance des électrodes 18. La largeur d'une électrode est de préférence d/4 mais chaque électrode peut être dédoublée en deux électrodes distinctes de largeur pratiquement égale à d/8 (pour des raisons d'élimination de réflexions au sein des peignes).

Les électrodes 18 n'arrivent pas jusqu'au plot 16 et les électrodes 20 n'arrivent pas au plot 14, mais elles s'étendent malgré tout sur la majeure partie de l'intervalle entre les deux plots, et la distance de recouvrement D entre deux électrodes consécutives est la même pour toutes les électrodes. Ce dernier point caractérise un peigne non modulé; la distance D pourrait varier pour les divers couples d'électrodes, auquel cas on aurait un peigne modulé.

Un peigne de réception 22, constitué exactement comme le peigne d'émission 12, avec deux plots 24 et 26, des électrodes 28 reliées au plot 24 et des électrodes 30 reliées au plot 26, est disposé en regard du peigne d'émission, les électrodes des deux peignes étant parallèles et en face les uns des autres. Le pas des électrodes 28 et des électrodes 30 est en principe le même que le pas des électrodes 18 et 20. Le peigne de réception est ici non modulé; il pourrait être modulé en coupant les électrodes en des points déterminés.

Le peigne d'émission a une largeur $L_e$ (perpendiculairement aux électrodes) beaucoup plus faible que la largeur $L_r$ du peigne de réception, c'est-à-dire qu'il comporte beaucoup moins d'électrodes.

Ces deux transducteurs 12 et 22 déposés sur le cristal constituent un dispositif de transmission, en ce sens qu'une tension électrique appliquée entre les bornes 14 et 16 engendre dans le cristal piézoélectrique des contraintes qui se propagent en surface dans la direction perpendiculaire aux électrodes rectilignes. Ces contraintes parviennent sous le peigne de réception où elles engendrent des variations de champ électrique détectées par les électrodes de sorte qu'il apparaît une tension de sortie entre les plots 24 et 26.

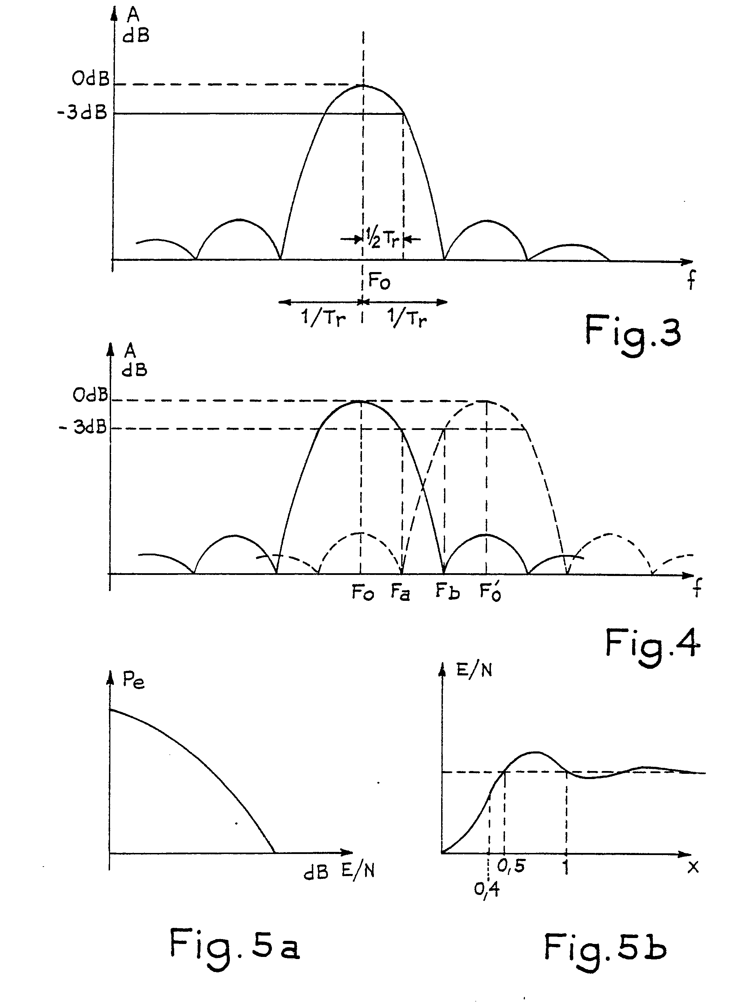

La courbe de réponse en fréquence d'un tel dispositif à peignes non modulés est représentée à la figure 3. Cette courbe de réponse est en module de sin x/x. Elle présente un maximum (atténuation zéro décibel par définition) à une fréquence $F_0$ qui est égale à v/d si v est la vitesse de propagation des ondes de surface et d le pas des électrodes reliées au même plot.

La courbe de réponse de la figure 3 présente des "zéros" (atténuation maximale) notamment à des fréquences écartées de la fréquence $F_0$ d'une valeur qui est l'inverse de la durée Tr de la réponse impulsionnelle du dispositif. Or, cette durée est égale au temps mis par une impulsion acoustique pour traverser complètement le peigne de réception, soit à $L_r$/v; les zéros de transmission du dispositif sont donc à une distance $1/T_r=v/L_r$ de la fréquence $F_0$.

En réalité, il faudrait décomposer la courbe de réponse du dispositif en une courbe de réponse du peigne de réception, ayant les caractéristiques indiquées ci-dessus et une courbe de réponse du peigne d'émission, ayant une forme analogue, centrée sur la fréquence $F_0$ car le pas d des électrodes est le même, mais beaucoup plus étalée en largeur car le peigne d'émission est beaucoup plus court que le peigne de réception et ses zéros de transmission sont rejetés à des fréquences $F_0+v/L_3$ et $F_0-v/L_e$ très éloignées de $F_0$. On considérera donc que le peigne d'émission a une réponse plate dans la bande intéressante qui se situe autour du lobe principal de la courbe de réponse du peigne de réception, et que la réponse impulsionnelle de l'ensemble est celle du peigne de réception.

Enfin, la courbe de réponse en fréquence a un affaiblissement à trois décibels sensiblement pour des fréquences $F_0+1/2T_r$ et $F_0-1/2T_r$.

La réponse en fréquence du dispositif ainsi décrit est donc déterminée essentiellement par le pas des électrodes (qui fixe $F_0$) et par la longueur du peigne de réception (qui fixe les zéros de transmission).

Bien que la courbe réponse de ce dispositif n'ait pas de flancs raides et de sommet plat, il présente pour l'invention l'intérêt capital d'avoir une réponse impulsionnelle particulièrement courte pour une valeur fixée des zéros de transmission désirés. Autrement dit, si on voulait réaliser un filtre avec les mêmes zéros de transmission mais avec une courbe de réponse à sommet plus plat et à flancs plus raides, on pourrait le faire avec un peigne de réception modulé de manière appropriée mais ce peigne aurait un nombre d'électrodes beaucoup plus élevé et aurait donc une réponse impulsionnelle beaucoup plus longue, avec un risque élevé d'interférences entre symboles binaires reçus. Ce dispositif de la figure 2 est donc avantageusement utilisé comme filtre dans le cadre de l'invention.

Selon un premier aspect de l'invention, on constitue sur un même substrat deux ensembles de filtrage à peignes non modulés tels que celui de la figure 2, mais leurs caractéristiques sont telles que leurs courbes de réponse sont décalées latéralement en fréquence pour donner les deux courbes visibles respectivement en traits pleins (premier filtre) et en traits pointillés (deuxième filtre) à la figure 4.

Les deux fréquences à démoduler $F_a$ et $F_b$ étant imposées, on choisit comme fréquence centrale du premier filtre

$$F_0=F_a-(F_b-F_a),$$

donc comme pas entre les électrodes du peigne d'émission et du peigne de réception

$$d=v/F_0=v/(2F_a-F_b),$$

et on choisit comme durée de réponse impulsionnelle $T_r$ tel que

$$1/T_r=2(F_b-F_a).$$

Il en résulte une largeur de peigne de réception

$$(L_r=vT_r=v/2(F_b-F_a).$$

Il faut donc prévoir un nombre d'électrodes égal à

$$(2F_a-F_b)/2(F_b-F_a)$$

reliées à chaque plot du peigne de réception, soit

$$(2F_a-F_b)/(F_b-F_a)$$

en tout.

Ce choix du pas d et du nombre d'électrodes du peigne de réception fixe pour le premier filtre un zéro, donc un affaiblissement très important à la fréquence $F_b$ et un affaiblissement peu important de 3 dB à la fréquence $F_a$ qui est juste au milieu de l'intervalle $(F_0, F_b)$.

Le deuxième filtre est réalisé sur le même cristal piézoélectrique avec un pas entre électrodes $d'=v/(2F_b-F_a)$ donnant une atténuation minimale à $F'_0=2F_b-F_a$ et le nombre d'électrodes du peigne de réception est choisi égal à

$$(2F_b-F_a)/2(F_b-F_a)$$

pour chaque plot, de manière à obtenir la même largeur de peigne que pour le premier filtre:

$$L'_r = L_r = v/2(F_b - F_a)$$

donc une durée de réponse impulsionnelle

$$T'_r = T_r = 1/2(F_b - F_a)$$

Comme on le voit sur la figure 4, ces paramètres d' et $L'_r$ choisis pour le deuxième filtre imposent un zéro de transmission à la fréquence $F_a$ et un affaiblissement peu important à la fréquence $F_b$ (3dB).

Chacun des filtres recevant les fréquences $F_a$ et $F_b$ ne sélectionnera donc que l'une des fréquences en atténuant très fortement l'autre.

Ainsi, ayant deux fréquences imposées $F_a$ et $F_b$, on a déterminé les caractéristiques de deux filtres permettant d'effectuer de manière très satisfaisante la séparation des signaux à ces deux fréquences.

Comme on l'a dit, la durée de réponse impulsionnelle des filtres à peignes non modulés est particulièrement courte et elle est égale ici à $1/2(F_b - F_a)$. Comme on peut recevoir des signaux modulés de façon binaire avec un durée de bit pratiquement égale à la réponse impulsionnelle sans risque d'interférence intersymboles, en pourra recevoir des signaux codés à un rythme élevé pour lequel la durée de bit est $1/2(F_b - F_a)$. Par exemple, si $F_b - F_a = 1$ MHz, la durée de bit peut être de 500 nanosecondes et le débit d'informations binaires reçues peut être de 2 Mbits/s.

Si les fréquences $F_a$ et $F_b$ sont respectivement de 70 et 71 MHz et si le cristal choisi est du niobate de lithium $LiNbO_3$ (v=3490 m/s), le premier filtre aura un peigne de réception à deux fois 34 ou 35 électrodes interdigitées dont le pas est de 50,5 microns, ce qui est parfaitement réalisable.

Le deuxième filtre aura deux fois 36 électrodes à un pas de 48 microns.

Le nombre d'électrodes des peignes d'émission doit être faible devant celui des peignes de réception: il peut être de deux fois 3 à 10 électrodes; il est choisi de manière à engendrer une énergie mécanique vibratoire suffisante dans le cristal.

Quant à la longueur des électrodes, elle est aussi choisie suffisante pour assurer à la fois une production et une récupération d'énergie suffisante et une bonne directivité de propagation (perpendiculairement aux électrodes). Une longueur de un à quelques millimètres s'avère adéquate. La largeur des électrodes est de préférence d/4.

On peut montrer que le choix de ces filtres est tout à fait optimal du point de vue de la probabilité d'erreurs de décodage à débit élevé en présence de bruit blanc: il a été établi par V. A. Kotelnikov dans "The theory of optimum noise immunity" Dover Inc, New York, que cette probabilité d'erreur $P_e$ décroit (courbe de la figure 5a) avec un paramètre E/N représentant le rapport de l'énergie par bit à la densité spectrale de bruit, ce paramètre devant donc si possible être maximisé pour minimiser la probabilité d'erreur. Or ce paramètre est une fonction en

$$(1 - \sin 2 .. x/2 .. x)$$

où x est le produit de la durée de bit T (représentant donc le rythme de transmission) par l'écart $(F_b - F_a)$ des fréquences de modulation: $x = T(F_b - F_a)$.

La courbe de variation de E/N en fonction de x est représentée à la figure 5b. On voit qu'elle présente un maximum pour x environ égal à 0,7. En tout état de cause, la courbe de x ondule mais entre des valeurs limitées acceptables de sorte que, pour avoir une probabilité d'erreur suffisamment faible on devra choisir x supérieur par exemple à 0,4 (au dessous E/N diminuerait trop et la probabilité d'erreur augmenterait beaucoup). Mais, tout en restant au dessus de cette valeur, il vaut mieux garder x aussi faible que possible car augmenter x reviendrait soit à augmenter T donc à diminuer le débit, soit à augmenter $F_a - F_b$ donc à augmenter la largeur de bande de modulation, ceci avec un bénéfice faible en termes de diminution de probabilité d'erreur.

Par conséquent x=0,5 est une valeur tout à fait appropriée pour obtenir une faible probabilité d'erreur et c'est justement la valeur que l'on a ici lorsqu'on choisit une durée de bit T égale à la durée de réponse impulsionnelle $T_r$ (pour minimiser les interférences intersymboles):

$$x = T(F_b - F_a) = T_r(F_b - F_a)$$

avec $T_r = 1/2(F_b - F_a)$, donc x=0,5.

Ces deux avantages conjugués de réduction des interférences intersymboles et de faible probabilité d'erreur ne sont toutefois pas liés à l'obtention exacte d'une valeur x=0,5: d'une part on pourrait prendre $T(F_b - F_a)$ de l'ordre de 0,4 sans augmenter beaucoup le taux d'erreurs; on pourrait donc par exemple augmenter le débit de transmission; d'autre part on peut prendre $T_r$ légèrement inférieur à la durée de bit à rythme élevé pour diminuer encore le risque d'interférence intersymboles tout en gardant une valeur de $T_r$ suffisante pour assurer la reconnaissance des fréquences qui se présentent à l'entrée.

Dans ces conditions, on peut imaginer des variantes de réalisation dans lesquelles les caractéristiques du filtre ne sont pas tout à fait les mêmes que celles données ci-dessus bien que ce soient les mêmes fréquences $F_a$ et $F_b$ que l'on cherche à détecter.

Dans une première variante, on considère qu'un certain niveau de bruit est présent dans le signal et qu'il n'est donc pas vraiment utile que les filtres atténuent la fréquence $F_a$ ou la fréquence $F_b$ au dessous de ce niveau; ou prévoit donc que pour le premier filtre le zéro de transmission n'est pas placé à $F_b$ mais à une valeur légèrement supérieure à $F_b$, l'affaiblissement restant cependant très important à $F_b$ de manière à atténuer le signal jusqu'au niveau du bruit. Il en est de même pour le deuxième filtre dont le zéro de transmission sera placé légèrement au dessous de $F_a$, l'affaiblissement à la fréquence $F_a$

étant tel qu'on atténue le signal jusqu'au niveau du bruit.

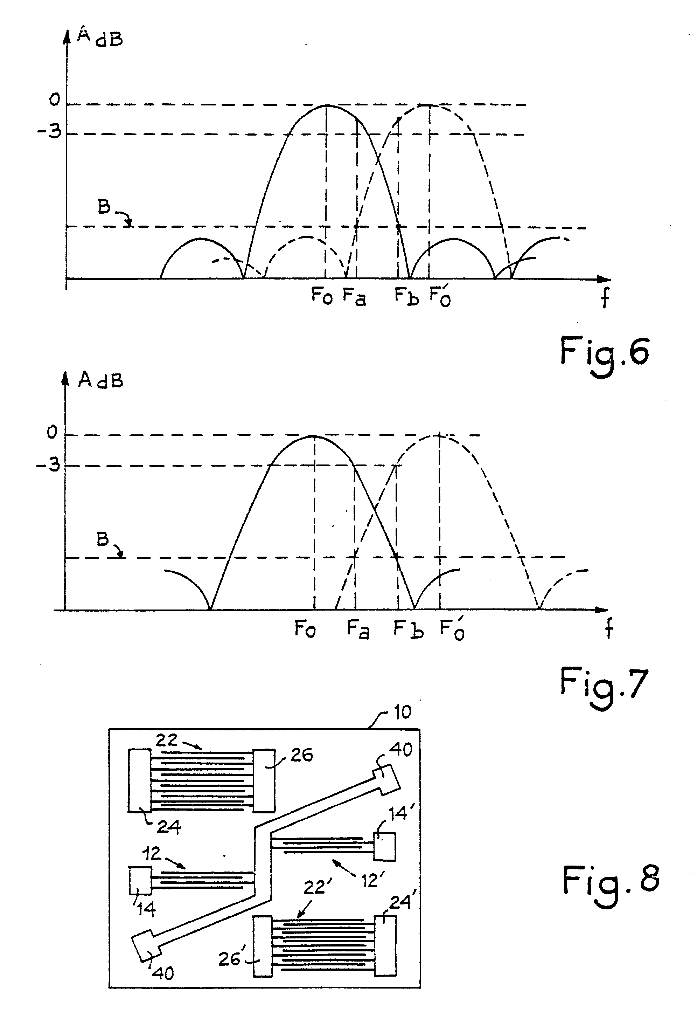

La figure 6 montre les courbes de réponse qui peuvent en résulter: un exemple de niveau de bruit est représenté par la ligne B. Par rapport à la figure 4, on a simplement décalé légèrement vers la droite la courbe de réponse du premier filtre (traits pleins), et vers la gauche celle du deuxième (traits tiretés).

Le filtre qui en résulte comprend donc deux ensembles de filtrage qui ont des caractéristiques voisines de celles mentionnées à propos de la figure 4. Mais le premier filtre aura une fréquence centrale $F_0$ légèrement supérieure à $2F_a - F_b$ donc des électrodes plus rapprochées. La longueur du peigne de réception sera la même; par conséquent le nombre d'électrodes sera légèrement plus élevé. L'inverse est vrai pour le deuxième filtre.

L'avantage qui en résulte est que l'atténuation du premier filtre à la fréquence $F_a$ et du deuxième à la fréquence $F_b$ est inférieure à 3 décibels: elle peut être par exemple de 1,5 à 2 décibels et le rapport signal/bruit en sortie est donc amélioré.

Dans la modification des filtres correspondant à la figure 6, on a choisi de garder la même largeur de peigne de réception, donc de décaler latéralement les courbes de la figure 4 sans modifier leur forme. A la figure 7, on propose de tenir compte du bruit de la même manière mais en aplatissant les courbes, c'est-à-dire en diminuant la largeur du peigne, ce qui revient à diminuer la durée de réponse impulsionnelle. Dans ce cas, l'atténuation des fréquences $F_a$ et $F_b$ est de nouveau à 3 décibels. Le premier filtre aura un pas d'électrodes qui sera encore sensiblement égal à $v/(2F_a - F_b)$ mais la largeur du peigne sera inférieure à $v/2(F_b - F_a)$.

Les mêmes remarques s'appliquent au deuxième filtre.

L'avantage de ce choix réside dans la réduction de la durée de réponse impulsionnelle qui permet donc une augmentation du débit de transmission d'informations tout en restant dans des conditions acceptables au point de vue de la probabilité d'erreur.

On pourrait évidemment aussi imaginer des solutions intermédiaires entre celles des Figures 6 et 7. De toutes façons, les courbes de réponse effectives obtenues ne seront que des approximations des courbes théoriques représentées, du fait que par exemple les nombres d'électrodes des peignes, théoriquement égaux à

$$(2F_a - F_b)/2(F_b - F_a)$$

ou

$$(2F_b - F_a)/2(F_b - F_a)$$

sont en réalité les nombres entiers les plus proches de ces valeurs.

En tous cas la caractéristique commune des filtres de démodulation selon l'invention, à peignes non modulés, est que leur durée de réponse impulsionnelle $T_r$ ou $T'_r$ est sensiblement égale à $0,5/(F_b - F_a)$, de préférence comprise entre $0,4/(F_b - F_a)$ et $0,5/(F_b - F_a)$, avec la largeur de peigne $L_r = vT_r$, et le nombre d'électrodes qui en résultant.

La figure 8 montre schématiquement la constitution d'un filtre de démodulation selon l'invention, comportant deux voies de filtrage atténuant les fréquences $F_b$ et $F_a$ selon les courbes des figures 4 ou 6 ou 7. Les nombres d'électrodes représentés sont arbitraires.

Le cristal piézoélectrique peut être en niobate de lithium $LiNbO_3$, en tantalate de lithium $LiTaO_3$ en quartz, en berlinite, en arséniure de gallium etc., les vitesses v de propagation des ondes élastiques de surface dans ces matériaux étant diverses et connues. Le cristal est désigné par 10 comme à la figure 2. Une large électrode 40 divise en deux parties la surface du cristal; elle sert de ligne de masse et de blindage électrostatique entre les deux voies. Cette électrode 40 constitue un point de référence pour le signal d'entrée.

Un premier ensemble de filtrage, situé d'un côté de l'électrode 40, comprend un peigne d'émission 12 à petit nombre d'électrodes interdigitées, s'étendant entre un plot 14 et l'électrode 40, et un peigne de réception 22 à plus grand nombre d'électrodes, parallèle au peigne d'émission et en regard de lui, s'étendant entre deux plots 24 et 26.

Un deuxième ensemble de filtrage est constitué de la même manière de l'autre côté de l'électrode 40; les mêmes références avec le signe prime (') désignent les éléments correspondants; les pas d'électrodes et nombre d'électrodes sont calculés comme expliqué en référence aux figures 4, 6 et 7. La distance entre le peigne d'émission et le peigne de réception est la même pour les deux ensembles de filtrage.

Le signal analogique à démoduler est appliqué simultanément aux plots 14 et 14' par rapport à l'électrode de référence commune 40.

La sortie du premier ensemble de filtrage est prélevée entre les plots 24 et 26 et celle du deuxième entre les plots 24' et 26'.

Ces sorties sont destinées à être couplées (voir figure 1) à deux détecteurs (filtres passe-bas) lesquels sont reliés aux entrées d'un comparateur.

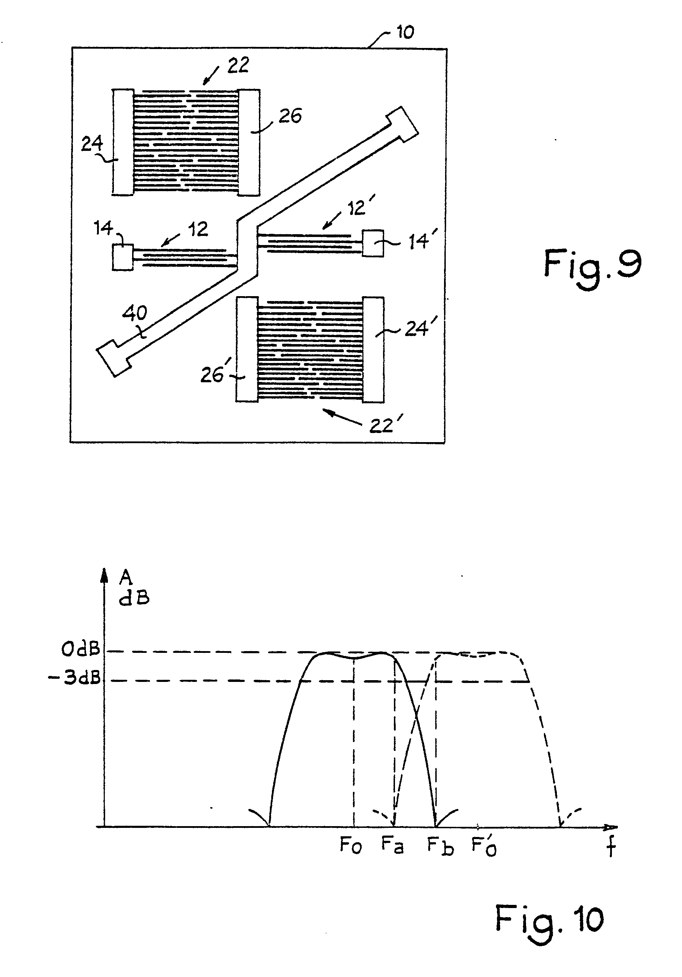

Une variante de réalisation de filtre de démodulateur F.S.K. selon l'invention est représentée à la figure 9: les ensembles de filtrage, disposés tout à fait comme ceux de la figure 8, présentent la particularité d'avoir chacun un peigne de réception modulé, c'est à dire dont les électrodes interdigitées sont coupées à des hauteurs variables.

Ces coupures permettent de modifier les courbes de réponse des figures 4, 6 et 7, notamment pour aplatir le sommet ou même créer des bosses et obtenir des flancs plus raides que la caurbe en sin x/x.

Les références portées sur la figure 9 sont les mêmes que pour les éléments correspondants de la figure 8; des peignes modulés 22 et 22' sont visibles. Ils ont une largeur et un nombre d'électrodes plus grand que ceux de la figure 8 car, pour que les courbes de réponse obtenues aient effectivement un sommet plus plat on des flancs plus raides que ceux d'un peigne non modulé ayant sensiblement les mêmes positions de zéro de transmission et de fréquence centrale de transmission, il est nécessaire de moduler les longueurs de recouvrement d'électrodes consécutives sur un assez grand nombre d'éléments, ce qui correspond d'ailleurs à une fonction de transfert polynômiale à nombre de coefficients relativement important.

La figure 10 représente un exemple de courbes de réponse fournies par deux ensembles de filtrage à peignes modulés.

L'une des courbes est centrée sur une fréquence $F_0$ sensiblement égale à $2F_a-F_b$ et l'autre sur $F'_0$ sensiblement égale à $2F_b-F_a$, ce qui détermine les pas des électrodes des deux ensembles de filtrage: $d=v/F_0$ et $d'=v/F'_0$.

Le premier filtre possède un zéro à $F_b$ (ou légèrement plus haut en fréquence en tenant compte des enseignements exposés à propos des figures 6 et 7), et l'autre filtre à $F_a$.

Les courbes de réponse sont plates et même bosselées de part et d'autre de la fréquence centrale, ce qui fait que l'atténuation du premier filtre à $F_a$ et du deuxième filtre à $F_b$ est très faible (moins de 1 décibel), et c'est là l'intérêt essentiel d'avoir des peignes modulés. Les courbes de réponse peuvent être dissymétriques et avoit un flanc plus raide entre $F_a$ et $F_b$ que de l'autre côté.

Cependant, il est très important de considérer que l'obtention d'un sommet plat et de flancs raides ne doit pas conduire à une largeur de peigne trop importante, faute de quoi on aboutirait, à débit élevé, à des interférences intersymboles importantes. Par conséquent, on se limite selon l'invention à des peignes dont la réponse impulsionnelle est de l'ordre de $0,5/(F_b-F_a)$, pouvant par exemple atteindre au plus le double de cette valeur; ceci détermine le nombre d'électrodes puisque le pas des électrodes est imposé: ce nombre serait donc compris, pour un filtre à peignes modulés, entre

$$(2F_a-F_b)/2(F_b-F_a)$$

et

$$(2F_a-F_b)/(F_b-F_a)$$

environ pour le premier filtre et entre

$$(2F_b-F_a)/2(F_b-F_a)$$

et

$$(2F_b-F_a)/(F_b-F_a)$$

environ pour le deuxième.

Dans une réalisation plus particulière de l'invention, on utilise l'aptitude des dispositifs à ondes de surface à établir non seulement un filtrage des signaux analogiques, mais aussi des déphasages.

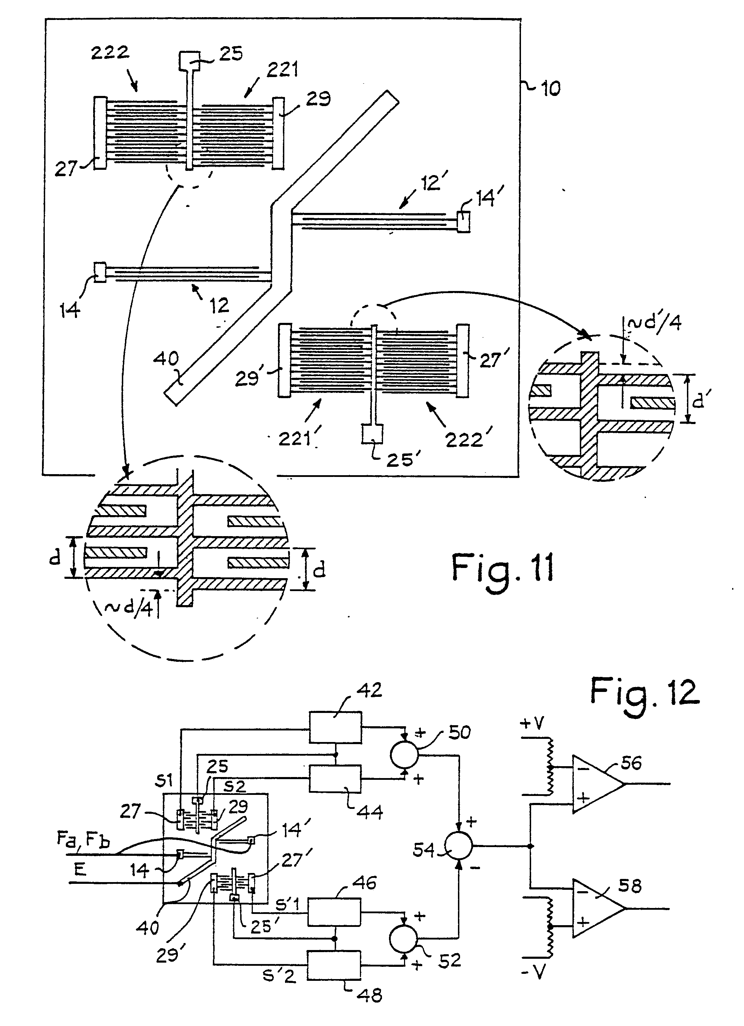

Le filtre de démodulation représenté à la figure 11 est réalisé sur le modèle de ceux des figures 8 ou 9, mais les peignes de réception des deux ensembles sont dédoublés: en face du peigne d'émission 12 (ou 12'), on a disposé deux peignes de réception 221 et 222 (221' et 222'); ces peignes comportent un plot commun 25 situé dans l'axe du peigne d'émission. Des électrodes s'étendent transversalement de part et d'autre de ce plot commun mais celles qui s'étendent d'un côté sont décalées dans (la direction de propagation) d'une distance environ égale à d/4 par rapport à celles qui s'étendent de l'autre côté. Les détails agrandis dans les cercles pointillés de la figure 11 montrent bien ce décalage.

Un peigne de réception interdigité 222 est formé d'un côté du plot 25 avec des électrodes s'étendant à partir d'un autre plot 27, et un autre peigne 221 est formé de l'autre côté avec des électrodes s'étendant à partir d'un autre plot 29. Les deux peignes placés côte à côte occupent une longueur équivalente à la longueur du peigne d'émission, c'est-à-dire que les électrodes de réception ont une longueur pratiquement moitié de la longueur des électrodes d'émission. Pour les peignes de réception 221' et 222' de la deuxième voie de filtrage, le décalage des électrodes des deux peignes est environ d'/4 et d' est le pas des électrodes de la deuxième voie de filtrage.

Ces peignes peuvent être modulés ou non. Les pas d et d' des électrodes et le nombre d'électrodes sont calculés comme celà a été expliqué précédemment en donnant aux peignes de réception une largeur $L_r$ (dans le sens de propagation des ondes) telles que la durée de réponse impulsionnelle soit sensiblement égale à $0,5/(F_b-F_a)$, par exemple entre $0,4/(F_b-F_a)$ et $0,5/(F_b-F_a)$ si les peignes ne sont pas modulés, ou entre $0,5/(F_b-F_a)$ et $1/(F_b-F_a)$, s'ils sont modulés. La modulation des peignes peut comporter un certain nombre de poids nuls.

Le filtre de la figure 11 est utilisé en démodulateur F.S.K. de la manière représentée à la figure 12.

Le signal d'entrée à démoduler est appliqué aux plots 14 et 14' simultanément, par rapport au plot commun 40.

Quatre signaux de sortie sont recueillis, respectivement un signal S1 et un signal S2 sur les plots 27 et 29 (par rapport au plot 25), et un signal S'1 et un signal S'2 sur les plots 27' et 29' par rapport au plot commun 25'.

Ces quatre signaux sont appliqués chacun à un dispositif d'élévation au carré, respectivement 42, 44, 46, 48, par exemple constitués par des diodes.

Les signaux S1 et S2 ainsi élevés au carré sont additionnés dans un sommateur 50, et les signaux S'1 et S'2 élevés au carré sont additionnés dans un sommateur 52. Les sorties des sommateurs sont appliquées aux entrées d'un soustracteur 54 qui fournit un signal d'un signe positif ou négatif selon la fréquence reçue; ce soustracteur peut être suivi de comparateurs à seuils 56 et 58 pour établir un signal binaire de sortie.

Le décalage des électrodes des peignes 221 et 222 d'une distance d/4 introduit un déphasage de 90° (à la fréquence $F_a$) entre les deux signaux de sortie S1 et S2 du premier ensemble de filtrage, et de même pour les signaux S'1 et S'2 à la fréquence $F_b$.

L'élévation au carré et l'addition de deux signaux sinusoïdaux déphasés de 90° revient à effectuer une somme du type $\cos^2+\sin^2$ qui est égale à 1. Par conséquent, dès lors qu'une fréquence $F_a$ est détectée par le premier ensemble de filtrage, la sortie du sommateur 50 fournit un signal continu dans lequel la fréquence $F_a$ a été éliminée sans dispositif de filtrage passe-bas. Ce filtre à deux demi-peignes déphasés dans chaque voie de filtrage permet donc une détection particulièrement simple des fréquences $F_a$ et $F_b$, avec une excellente élimination du bruit qui est élevé au carré et soustrait entre les deux voies.

On notera que le décalage entre les deux demi-peignes de réception 221 et 222 (ou 221' et 222') a été choisi égal à d/4 par simplification. En réalité, pour obtenir un déphasage de 90° exactement à la fréquence $F_a$, il faut un décalage égal à $v/4F_a$ alors que d/4 est égal à $v/4(2F_a-F_b)$.

De même un pourra adopter un décalage d'électrodes $v/4F_b$ plus précis que

$$d'/4=v/4(2F_b-F_a)$$

pour les peignes 221' et 222'.

Les filtres de démodulation selon l'invention peuvent servir dans une gamme de fréquences allant par exemple de 30 à 300 MHz ou même plus.

Dans ce qui précède, on a surtout considéré que le peigne de réception avait un grand nombre d'électrodes et pouvait être modulé, le peigne d'émission ayant moins d'électrodes et n'étant pas modulé, mais on peut inverser les rôles des peignes et on peut aussi prévoir que la modulation des longueurs d'électrodes est répartie entre le peigne d'émission et le peigne de réception.

**Revendications**

1. Circuit comprenant, à la surface d'un cristal piézoélectrique (10), deux ensembles de filtrage à ondes acoustiques de surface utilisant des transducteurs à peignes d'électrodes interdigitées (12, 12', 22, 22') déposées sur le cristal, ces ensembles de filtrage recevant tous deux un signal et ayant une réponse impulsionnelle finie de durée $T_r$, le premier ensemble de filtrage ayant une courbe de réponse en fréquence présentant un affaiblissement relatif très important à la fréquence $F_b$ et peu important à la fréquence $F_a$, et le deuxième ensemble de filtrage présentant un affaiblissement très important à la fréquence $F_a$ et peu important à la fréquence $F_b$, ce circuit étant caractérisé en ce que, pour constituer un filtre pour la démodulation d'un signal analogique qui est modulé en fréquence selon un code binaire par commutation de la fréquence du signal entre les deux fréquences $F_a$ et $F_b$ ($F_b$ supérieur à $F_a$), chaque ensemble de filtrage comprend un premier peigne (12, 12') de quelques électrodes et un second peigne (22, 22') ayant un nombre d'électrodes notablement plus grand, sensiblement égal à deux fois

$$(2F_a-F_b)/2(F_b-F_a)$$

pour le premier ensemble et deux fois

$$(2F_b-F_a)/2(F_b-F_a)$$

pour le deuxième, le pas d des électrodes successives reliées à un même potentiel étant pratiquement égal à $v/(2F_a-F_b)$ pour le premier ensemble et $v/(2F_b-F_a)$ pour le deuxième, où v est la vitesse de propagation des ondes à la surface du cristal piézoélectrique, et en ce que la réponse impulsionnelle de durée $T_r$ est sensiblement égale à $0,5/(F_b-F_a)$.

2. Filtre de démodulation selon la revendication 1, caractérisé par le fait que les seconds peignes (22, 22') ne sont pas modulés et que leur nombre d'électrodes est compris entre deux fois

$$0,8(2F_a-F_b)/2(F_b-F_a)$$

et

$$(2F_a-F_b)/2(F_b-F_a)$$

pour le premier ensemble de filtrage et entre deux fois

$$0,8(2F_b-F_a)/2(F_b-F_a)$$

et

$$(2F_b-F_a)/(F_b-F_a)$$

pour le deuxième.

3. Filtre de démodulation selon la revendication 1, caractérisé par le fait que les seconds peignes (22, 22') sont modulés et que leur nombre d'électrodes est compris entre

$$(2F_a-F_b)/2(F_b-F_a)$$

et

$$(2F_a-F_b)/(F_b-F_a)$$

pour le premier ensemble de filtrage en entre

$$(2F_b-F_a)/2(F_b-F_a)$$

et

$$(2F_b-F_a)/(F_b-F_a)$$

pour le deuxième.

4. Filtre de démodulation selon l'une des revendications 1 à 3 caractérisé par le fait que la surface du cristal piézoélectrique est divisée en deux zones par une électrode large (40) reliée à la moitié des électrodes de chacun des peignes d'émission, cette électrode servant de référence de tension pour le signal analogique à démoduler et servant de blindage électrostatique entre les deux zones.

5. Filtre de démodulation selon l'une des revendications 1 à 4 caractérisé par le fait que, pour chacun des deux ensembles de filtrage, il est prévu, en regard d'un peigne d'émission (12, 12'), deux peignes de réception juxtaposés (221, 222, 221', 222') ayant des électrodes interdigitées au même pas, l'un des deux peignes de réception ayant ses électrodes décalées par rapport à celles de l'autre dans la direction perpendiculaire aux électrodes, le décalage ayant une valeur d'environ $v/4F_a$ pour le premier ensemble de filtrage et $v/4F_b$ pour le deuxième, où v est la vitesse de propagation des ondes de surface.

## Patentansprüche

1. Schaltkreis, enthaltend auf der Oberfläche eines piezoelektrischen Kristalls (10) zwei Filteranordnungen für akustische Oberflächenwellen, die Wandler aus ineinandergreifenden Kammelektroden (12, 12', 22, 22'), die auf dem Kristall angeordnet sind, verwenden, wobei diese Filteranordnungen beide ein Signal erhalten und eine endliche Impulsantwort der Dauer $T_r$ haben, die erste Filteranordnung eine Frequenzgangkurve hat, die einen relativ ausgeprägten Abfall bei der Frequenz $F_b$ und einen wenig bedeutsamen bei der Frequenz $F_a$ hat, und die zweite Filteranordnung einen ausgeprägten Abfall bei der Frequenz $F_a$ und einen weniger bedeutsamen bei der Frequenz $F_b$ hat, wobei dieser Schaltkreis dadurch gekennzeichnet ist, daß um ein Filter für die Demodulation eines Analogsignals zu bilden, das nach einem Binärkode frequenzmoduliert ist durch Umschalten der Signalfrequenz zwischen den zwei Frequenzen $F_a$ und $F_b$ ($F_b$ größer als $F_a$), jede Filteranordnung einen ersten Kamm (12, 12') aus einigen Elektroden und einen zweiten Kamm (22, 22') aufweist, der eine merklich größere Zahl von Elektroden hat, etwa gleich dem Zweifachen

$$(2F_a-F_b)/2(F_b-F_a)$$

für die erste Anordnung und dem Zweifachen

$$(2F_b-F_a)/2(F_b-F_a)$$

für die zweite, wobei die Teilung d der aufeinanderfolgenden Elektroden, die an dasselbe Potential angeschlossen sind, praktisch gleich $v/(2F_a-F_b)$ für die erste Anordnung und $v/(2F_b-F_a)$ für die zweite ist, wobei v die Ausbreitungsgeschwindigkeit der Wellen auf der Oberfläche des piezoelektrischen Kristalls ist, und daß die Impulsantwort der Dauer $T_r$ etwa gleich $0,5/(F_b-F_a)$ ist.

2. Demodulationsfilter nach Anspruch 1, gekennzeichnet durch die Tatsache, daß die zweiten Kämme (22, 22') nicht moduliert sind und daß ihre Elektrodenanzahl zwischen dem Zweifachen

$$0,8(2F_a-F_b)/2(F_b-F_a)$$

und

$$(2F_a-F_b)/2(F_b-F_a)$$

für die erste Filteranordnung und zwischen dem Zweifachen

$$0,8(2F_b-F_a)/2(F_b-F_a)$$

und

$$(2F_b-F_a)/(F_b-F_a)$$

für die zweite ist.

3. Demodulationsfilter nach Anspruch 1, gekennzeichnet durch die Tatsache, daß die zweiten Kämme (22, 22') moduliert sind und daß ihre Elektrodenzahl zwischen

$$(2F_a-F_b)/2(F_b-F_a)$$

und

$$(2F_a-F_b)/(F_b-F_a)$$

für die erste Filteranordnung und zwischen

$$(2F_b-F_a)/2(F_b-F_a)$$

und

$$(2F_b-F_a)/(F_b-F_a)$$

für die zweite liegt.

4. Demodulationsfilter nach einem der Ansprüche 1 bis 3, gekennzeichnet durch die Tatsache, daß die Oberfläche des piezoelektrischen Kristalls durch eine große Elektrode (40), die mit der Hälfte der Elektroden jeder der Emissionskämme verbunden ist, in zwei Zonen unterteilt ist, wobei diese Elektrode als Spannungsbezug für das zu demodulierende Analogsignal dient und als elektrostatische Abschirmung zwischen den zwei Zonen dient.

5. Demodulationsfilter nach einem der Ansprüche 1 bis 4, gekennzeichnet durch die Tatsache, daß für jede der Filteranordnungen gegenüber einem Emissionskamm (12, 12') zwei benachbarte Rezeptionskämme (221, 222, 221', 222') angeordnet sind, die ineinandergreifende Elektroden gleichen Teilungsabstands haben, wobei einer der Rezeptionskämme mit seinen Elektroden gegenüber jenen des anderen in der Richtung senkrecht zu den Elektroden versetzt ist, wobei der Versatz eine Größe von etwa $v/4F_a$ für die erste Filteranordnung und $v/4F_b$ für die zweite hat, wobei v die Ausbreitungsgeschwindigkeit der Oberflächenwellen ist.

## Claims

1. A circuit which comprises, on the surface of a piezoelectric crystal (10), two filter assemblies for surface acoustic waves, employing transducers (12, 12', 22, 22') in the form of interdigitated electrodes, deposited on the crystal, said filter assemblies both receiving a signal and having a finite impulse response of duration $T_r$, the first filter assembly having a frequency response curve exhibiting a weakening which is relatively very important at the frequency $F_b$ and of little importance at the frequency $F_a$, and the second filter assembly exhibiting a weakening which is relatively very important at the frequency $F_a$ and of little importance at the frequency $F_b$, said circuit being characterised in that, to constitute a filter for the demodulation of an analog signal which is frequency modulated according to a binary code by switching the signal frequency between the two frequencies $F_a$ and $F_b$ ($F_b$ being greater than $F_a$), each filter assembly comprises a first comb (12, 12') having a plurality of electrodes and a second comb (22, 22') having a substantially larger number of electrodes, substantially equal to twice

$$(2F_a - F_b)/2(F_b - F_a)$$

for the first assembly, and twice

$$(2F_b - F_a)/2(F_b - F_a)$$

for the second assembly, the distance d between successive electrodes connected at a same potential being substantially equal to $v/(2F_a - F_b)$ for the first assembly and $v/(2F_b - F_a)$ for the second, where v is the speed of propagation of surface waves on the piezoelectric crystal, and that the impulse response of duration $T_r$ is substantially equal to $0.5/(F_b - F_a)$.

2. Demodulation filter according to Claim 1, characterized in that the second combs (22, 22') are not modulated, and that the number of electrodes therein is comprised between twice

$$0.8(2F_a - F_b)/2(F_b - F_a)$$

and

$$(2F_a - F_b)/2(F_b - F_a)$$

for the first filter assembly and between twice

$$0.8(2F_b - F_a)/2(F_b - F_a)$$

and

$$(2F_b - F_a)/(F_b - F_a)$$

for the second assembly.

3. Demodulation filter according to Claim 1, characterized in that the second combs (22, 22') are modulated and that the number of electrodes therein is between

$$(2F_a - F_b)/2(F_b - F_a)$$

and

$$(2F_a - F_b)/(F_b - F_a)$$

for the first filter assembly and between

$$(2F_b - F_a)/(2F_b - F_a)$$

and

$$(2F_b - F_a)/(F_b - F_a)$$

for the second assembly.

4. Demodulation filter according to any one of Claims 1 to 3, characterized in that the surface of the piezoelectric crystal is divided into two zones by a broad electrode (40) connected to half the electrodes of each of the emission combs, said electrode acting as a potential reference for the analog signal to be modulated and providing electrostatic shielding between the two zones.

5. Demodulation filter according to any one of Claims 1 to 4, characterized in that two juxtaposed reception combs (221, 222, 221', 222') having interdigitated electrodes the same distance apart, and facing a single emission comb (12, 12') are provided for each of the two filter assemblies, one of the two reception combs having its electrodes offset with respect to those of the other in a direction perpendicular to the electrodes, the offset having a value of around $v/4F_a$ for the first filter assembly and $v/4F_b$ for the second assembly, where v is the speed of propagation of the surface waves.

Fig.1

Fig.2

Fig.3

Fig.4

Fig.5a

Fig.5b

0 092 474

Fig.6

Fig.7

Fig.8

5

Fig.9

Fig. 10

Fig. 11

Fig. 12